# EUROPÄISCHE PATENTANMELDUNG

(11) **EP 3 001 204 A1**
(43) Veröffentlichungstag der Anmeldung: **30.03.2016**
(21) Anmeldenummer: 14186773.9
(22) Anmeldetag: 29.09.2014
(51) Int. Cl.: G01R 15/18, H01B 17/26, H01F 38/00, H02B 13/00

(54) **Durchführung wenigstens eines elektrischen Leiters durch eine Öffnung**

(71) Anmelder: Siemens Aktiengesellschaft, 80333 München (DE)
(72) Erfinder: Mairinger, Martin, 4040 Linz (AT); Möhl, Andreas, 90478 Nürnberg (DE); Shah, Krishna, 82166 Gräfelfing (DE); Hammer, Thomas, 91126 Schwabach (DE)

(57) **Zusammenfassung**

Die Erfindung betrifft eine Vorrichtung (1) zur Durchführung wenigstens eines elektrischen Leiters (3) durch eine Öffnung. Die Vorrichtung (1) umfasst ein Gehäuse (5), das einen Hohlraum zur Aufnahme des wenigstens einen elektrischen Leiters (3) umgibt, und einen in das Gehäuse (5) integrierten Stromsensor (25) zur Erfassung einer Stromstärke eines durch den wenigstens einen elektrischen Leiter (3) fließenden elektrischen Stroms.

## Beschreibung

Die Erfindung betrifft eine Vorrichtung zur Durchführung wenigstens eines elektrischen Leiters durch eine Öffnung.

Insbesondere betrifft die Erfindung eine Vorrichtung zur Durchführung wenigstens eines elektrischen Leiters durch eine Öffnung in einem Gehäuse eines Transformators oder einer Schaltanlage.

Derartige Vorrichtungen werden auch einfach als Durchführungen bezeichnet. Häufig wird ein Stromfluss durch eine Durchführung gemessen, um bestimmte Überwachungs-, Steuer- oder Regelvorgänge durchführen zu können, beispielsweise zur Anzeige des Stromflusses auf einem Messinstrument zur Information eines Betreibers zur Lokal- oder Ferndiagnose und/oder zur Schaltung eines Relais zur Laststeuerung und/oder zur Trennung von einem Netz als Schutzschaltung. Für derartige Zwecke werden die Durchführungen mit einer Verlängerung versehen, so dass an der Verlängerung ein Stromwandler montiert werden kann. Diese Stromwandler werden in Abhängigkeit von einem Strom- und/oder Spannungsniveau derart dimensioniert, das ihre Ausgangsleistung ausreicht, die benötigten Verbraucher wie Messinstrumente oder Relais anzusteuern. Dies führt durch die Verlängerung der Durchführungen zu einer Erhöhung des Gewichts und Bauraumbedarfs der Durchführungen sowie durch die Stromsensorik zu einer Erhöhung der Systemkosten, die zwischen 10 % und 30 % dieser Kosten betragen kann.

Der Erfindung liegt die Aufgabe zugrunde, eine verbesserte Vorrichtung zur Durchführung wenigstens eines elektrischen Leiters durch eine Öffnung anzugeben.

Die Aufgabe wird erfindungsgemäß durch die Merkmale des Anspruchs 1 gelöst.

Vorteilhafte Ausgestaltungen der Erfindung sind Gegenstand der Unteransprüche.

Eine erfindungsgemäße Vorrichtung zur Durchführung wenigstens eines elektrischen Leiters durch eine Öffnung, umfasst ein Gehäuse, das einen Hohlraum zur Aufnahme des wenigstens einen elektrischen Leiters umgibt, und einen in das Gehäuse integrierten Stromsensor zur Erfassung einer Stromstärke eines durch den wenigstens einen elektrischen Leiter fließenden elektrischen Stroms.

Durch die Integration eines Stromsensors in das Gehäuse der Durchführung kann ein Stromfluss durch die Durchführung erfasst werden, ohne einen zusätzlichen Stromwandler an dem Gehäuse anzuordnen und ohne das Gehäuse dazu verlängern zu müssen. Dadurch werden vorteilhaft sowohl der Bauraum und das Gewicht des Gehäuses als auch die Komplexität und Kosten für die Sensorik zur Erfassung des Stromflusses reduziert. Durch die Vereinfachung der Sensorik zur Erfassung des Stromflusses lassen sich auch darauf beruhende Überwachungs-, Steuerungsund Regelungsaufgaben einfacher und kostengünstiger realisieren.

Eine Ausgestaltung der Erfindung sieht vor, dass der Stromsensor eine elektrische Spule umfasst.

Dadurch lässt sich der Stromsensor in besonders einfacher und kostengünstiger Weise realisieren, indem eine in der Spule durch den Stromfluss in dem wenigstens einen Leiter induzierte Spannung erfasst wird.

Vorzugsweise ist die elektrische Spule dabei derart angeordnet, dass sie Spulenwindungen aufweist, die um eine Stromflussrichtung des wenigstens einen elektrischen Leiters herum geführt sind.

Diese Anordnung der Spule ermöglicht eine besonders hohe in der Spule induzierte Spannung und damit vorteilhaft ein besonders gut auswertbares Messsignal des Stromsensors.

Eine weitere Ausgestaltung der Erfindung sieht einen Verstärker mit einem Eingang, der mit dem Stromsensor elektrisch verbunden ist, vor.

Dadurch kann das Messsignal des Stromsensors vorteilhaft verstärkt werden.

Vorzugsweise ist ein Ausgang des Verstärkers ferner mit einem Messinstrument und/oder einem Relais und/oder einem Analog-Digital-Wandler verbunden.

Diese Ausgestaltungen ermöglichen vorteilhaft, durch den Verstärker verstärkte Messsignale des Stromsensors zur Messung und Überwachung des Stromflusses mittels eines Messinstruments und/oder zu einer Laststeuerung oder Trennung des wenigstens einen elektrischen Leiters von einem elektrischen Netz mittels eines Relais zu nutzen und/oder mittels eines Analog-Digital-Wandlers für eine Digitallogik aufzubereiten.

Bevorzugt wird eine erfindungsgemäße Vorrichtung insbesondere zur Durchführung elektrischer Leiter aus Transformator- oder Schaltanlagengehäusen verwendet.

Dementsprechend umfasst ein erfindungsgemäßer Transformator ein Transformatorgehäuse, das eine Öffnung aufweist, und eine erfindungsgemäße Vorrichtung, mittels derer wenigstens ein elektrischer Leiter durch die Öffnung des Transformatorgehäuses geführt ist.

Eine erfindungsgemäße Schaltanlage umfasst ein Schaltanlagengehäuse, das eine Öffnung aufweist, und eine erfindungsgemäße Vorrichtung, mittels derer wenigstens ein elektrischer Leiter durch die Öffnung des Schaltanlagengehäuses geführt ist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: ein erstes Ausführungsbeispiel einer Vorrichtung zur Durchführung wenigstens eines elektrischen Leiters durch eine Öffnung in einer Seitenansicht,
- FIG 2: ein Blockdiagramm eines zweiten Ausführungsbeispiels einer Vorrichtung zur Durchführung wenigstens eines elektrischen Leiters durch eine Öffnung,
- FIG 3: schematisch in einer Seitenansicht einen Transformator, und
- FIG 4: schematisch in einer Seitenansicht eine Schaltanlage.

Einander entsprechende Teile sind in den Figuren mit den gleichen Bezugszeichen versehen.

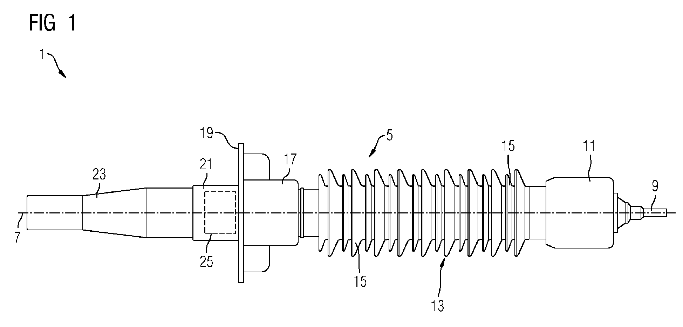

Figur 1 zeigt ein erstes Ausführungsbeispiel einer Vorrichtung 1 zur Durchführung wenigstens eines (in Figur 1 nicht dargestellten) elektrischen Leiters 3 durch eine Öffnung in einer Seitenansicht.

Die Vorrichtung 1 umfasst ein Gehäuse 5, das einen Hohlraum zur Aufnahme des wenigstens einen elektrischen Leiters 3 umgibt. Die Vorrichtung 1 ist im Wesentlichen rotationssymmetrisch bezüglich einer Längsachse 7 der Vorrichtung 1 ausgebildet. Die Längsachse 7 definiert eine axiale Richtung, entlang derer der wenigstens eine elektrische Leiter 3 innerhalb des Gehäuses 5 geführt wird.

An einem ersten axialen Ende weist die Vorrichtung 1 einen elektrischen Anschluss 9 auf, der aus einem Durchführungskopf 11 der Vorrichtung 1 herausragt. Der elektrische Anschluss 9 ist beispielsweise aus einer versilberten Kupferlegierung gefertigt.

An den Durchführungskopf 11 schließt sich axial auf der von dem elektrischen Anschluss 9 abgewandten Seite ein Isolationskörper 13 an. Der Isolationskörper 13 ist beispielsweise aus Porzellan gefertigt und weist vorzugsweise eine Anzahl von tellerrandartig zu einer Außenseite des Isolationskörpers 13 abstehenden und axial hintereinander angeordneten Isolatorrippen 15 auf.

An den Isolationskörper 13 schließt sich axial auf der von dem Durchführungskopf 11 abgewandten Seite ein Flanschbereich 17 mit einem Flansch 19 zur Befestigung der Vorrichtung 1 an.

An den Flanschbereich 17 schließt sich axial auf der von dem Isolationskörper 13 abgewandten Seite eine Bodenhülse 21 des Gehäuses 5 an.

An einem zweiten axialen Ende weist die Vorrichtung 1 einen sich an die Bodenhülse 21 axial anschließenden Endbereich 23 des Gehäuses 5 auf. Der Endbereich 23 verengt sich in einem mittleren Abschnitt zu dem zweiten axialen Ende der Vorrichtung 1 hin. Vorzugsweise ist der Endbereich 23 aus einem elektrisch isolierenden Material, beispielsweise aus einem Epoxidharz gefertigt.

In das Gehäuse 5 ist ein Stromsensor 25 zur Erfassung einer Stromstärke eines durch den wenigstens einen elektrischen Leiter 3 fließenden elektrischen Stroms integriert. Der Stromsensor 25 umfasst beispielsweise eine elektrische Spule, die Spulenwindungen aufweist, die um die Längsachse 7 herum geführt sind.

In dem in Figur 1 dargestellten Ausführungsbeispiel ist der Stromsensor 25 in der Bodenhülse 21 angeordnet. In anderen Ausführungsbeispielen kann der Stromsensor 25 jedoch auch in einem anderen Abschnitt des Gehäuses 5, beispielsweise in dem Isolationskörper 13, angeordnet sein.

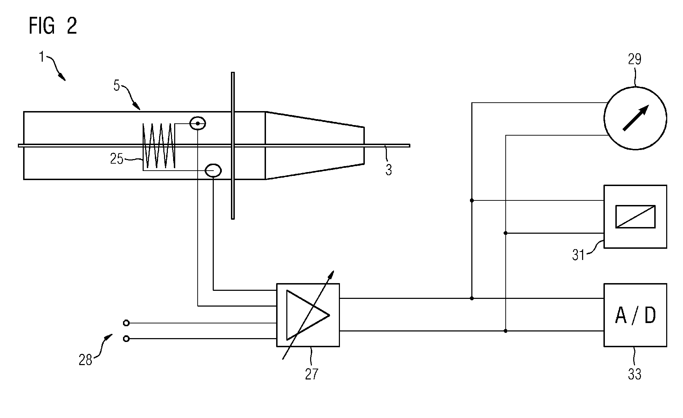

Figur 2 zeigt ein Blockdiagramm eines zweiten Ausführungsbeispiels einer Vorrichtung 1 zur Durchführung wenigstens eines elektrischen Leiters 3 durch eine Öffnung.

Die Vorrichtung 1 weist ein Gehäuse 5 auf, das einen Hohlraum zur Aufnahme des wenigstens einen elektrischen Leiters 3 umgibt. Das Gehäuse 5 ist beispielsweise wie das Gehäuse 5 des in Figur 1 dargestellten ersten Ausführungsbeispiels ausgebildet und daher in Figur 2 nicht noch einmal im Detail dargestellt. In das Gehäuse 5 ist wiederum ein Stromsensor 25 integriert, der beispielsweise als eine elektrische Spule zur Erfassung einer Stromstärke eines durch den wenigstens einen elektrischen Leiter 3 fließenden elektrischen Stroms ausgebildet ist.

Die Vorrichtung 1 umfasst ferner einen Verstärker 27 mit einem Eingang, an den der Stromsensor 25 angeschlossen ist. Zur Energieversorgung des Verstärkers 27 ist der Verstärker 27 an eine elektrische Spannungsquelle 28 anschließbar. Der Verstärker 27 ist vorzugsweise skalierbar und/oder als eine Schaltung ausgebildet, die sich selbst justiert oder in einem Prüffeld in einfacher Weise justiert werden kann.

Optional umfasst die Vorrichtung 1 ferner ein an einen Ausgang des Verstärkers 27 angeschlossenes Messinstrument 29 und/oder ein an einen Ausgang des Verstärkers 27 angeschlossenes Relais 31 und/oder einen an einen Ausgang des Verstärkers 27 angeschlossenen Analog-Digital-Wandler 33. Das Messinstrument 29 dient beispielsweise zur Messung und Anzeige des von dem Stromsensor 25 erfassten Stromflusses. Das Relais 31 dient beispielsweise zu einer Laststeuerung oder als Schutzschalter zu einer Trennung des wenigstens einen elektrischen Leiters 3 von einem elektrischen Netz. Der Analog-Digital-Wandler 33 dient beispielsweise zur Nutzung von dem Stromsensor 25 erfasster Signale in einer Digitallogik.

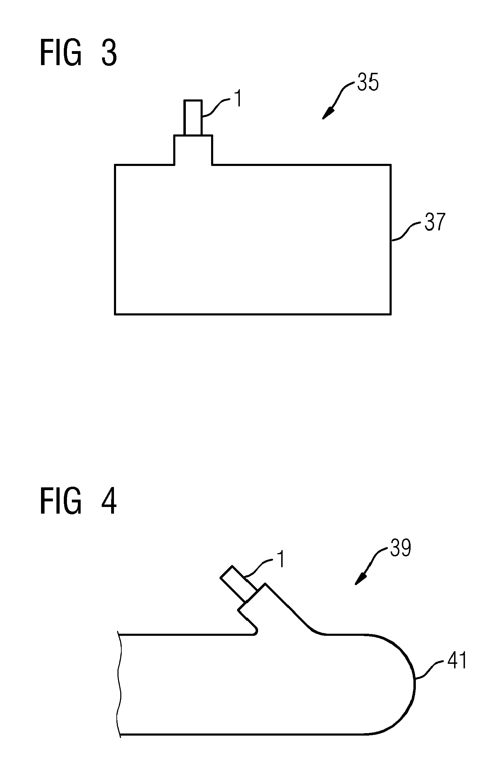

Figur 3 zeigt schematisch in einer Seitenansicht einen Transformator 35 mit einem Transformatorgehäuse 37, das eine Öffnung aufweist, und mit einer erfindungsgemäßen Vorrichtung 1, mittels derer wenigstens ein elektrischer Leiter 3 durch die Öffnung des Transformatorgehäuses 37 geführt ist.

Figur 4 zeigt schematisch in einer Seitenansicht eine Schaltanlage 39 mit einem Schaltanlagengehäuse 41, das eine Öffnung aufweist, und mit einer erfindungsgemäßen Vorrichtung 1, mittels derer wenigstens ein elektrischer Leiter 3 durch die Öffnung des Schaltanlagengehäuses 41 geführt ist. Die Schaltanlage 39 ist beispielsweise als ein Leistungsschalter ausgebildet.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Vorrichtung (1) zur Durchführung wenigstens eines elektrischen Leiters (3) durch eine Öffnung, umfassend
- ein Gehäuse (5), das einen Hohlraum zur Aufnahme des wenigstens einen elektrischen Leiters (3) umgibt,
- und einen in das Gehäuse (5) integrierten Stromsensor (25) zur Erfassung einer Stromstärke eines durch den wenigstens einen elektrischen Leiter (3) fließenden elektrischen Stroms.

2. Vorrichtung (1) nach Anspruch 1,
**dadurch gekennzeichnet, dass** der Stromsensor (25) eine elektrische Spule umfasst.

3. Vorrichtung (1) nach Anspruch 2,
**dadurch gekennzeichnet, dass** die elektrische Spule derart angeordnet ist, dass sie Spulenwindungen aufweist, die um eine Stromflussrichtung des wenigstens einen elektrischen Leiters (3) herum geführt sind.

4. Vorrichtung (1) nach einem der vorhergehenden Ansprüche,
**gekennzeichnet durch** einen Verstärker (27) mit einem Eingang, der mit dem Stromsensor (25) elektrisch verbunden ist.

5. Vorrichtung (1) nach Anspruch 4,
**gekennzeichnet durch** ein Messinstrument (29), das mit einem Ausgang des Verstärkers (27) verbunden ist.

6. Vorrichtung (1) nach Anspruch 4 oder 5,
**gekennzeichnet durch** ein Relais (31), das mit einem Ausgang des Verstärkers (27) verbunden ist.

7. Vorrichtung (1) nach einem der Ansprüche 4 bis 6,
**gekennzeichnet durch** einen Analog-Digital-Wandler (33), der mit einem Ausgang des Verstärkers (27) verbunden ist.

8. Transformator (35) mit einem Transformatorgehäuse (37), das eine Öffnung aufweist, und mit einer Vorrichtung (1) gemäß einem der vorhergehenden Ansprüche, mittels derer wenigstens ein elektrischer Leiter (3) durch die Öffnung des Transformatorgehäuses (37) geführt ist.

9. Schaltanlage (39) mit einem Schaltanlagengehäuse (41), das eine Öffnung aufweist, und mit einer Vorrichtung (1) gemäß einem der Ansprüche 1 bis 7, mittels derer wenigstens ein elektrischer Leiter (3) durch die Öffnung des Schaltanlagengehäuses (41) geführt ist.
